# EUROPÄISCHE PATENTSCHRIFT

(11) **EP 1 129 466 B1**
(45) Veröffentlichungstag und Bekanntmachung des Hinweises auf die Patenterteilung: **13.10.2010**
(21) Anmeldenummer: 00965780.0
(22) Anmeldetag: 23.08.2000
(51) Int. Cl.: H01J 37/32, H05H 1/46

(54) **VORRICHTUNG UND VERFAHREN ZUR ERZEUGUNG EINES LOKALEN PLASMAS DURCH MIKROSTRUKTURELEKTRODENENTLADUNGEN MIT MIKROWELLEN**
DEVICE AND METHOD FOR GENERATING A LOCAL PLASMA BY MICRO-STRUCTURE ELECTRODE DISCHARGES WITH MICROWAVES
DISPOSITIF ET PROCEDE POUR PRODUIRE UN PLASMA LOCAL PAR DES DECHARGES D'ELECTRODE A MICROSTRUCTURE AVEC DES MICRO-ONDES

(30) Priorität: 14.09.1999 DE 19943953
(43) Veröffentlichungstag der Anmeldung: 05.09.2001
(73) Patentinhaber: ROBERT BOSCH GMBH, 70442 Stuttgart (DE)
(72) Erfinder: GROSSE, Stefan, 70839 Gerlingen (DE); VOIGT, Johannes, 71229 Leonberg (DE)
(86) Internationale Anmeldenummer: PCT/DE2000/002877
(87) Internationale Veröffentlichungsnummer: WO 2001/020640

(56) Entgegenhaltungen:
- FRAME J W ET AL: "MICRODISCHARGE DEVICES FABRICATED IN SILICON" APPLIED PHYSICS LETTERS,US,AMERICAN INSTITUTE OF PHYSICS. NEW YORK, Bd. 71, Nr. 9, 1. September 1997 (1997-09-01), Seiten 1165-1167, XP000720227 ISSN: 0003-6951 in der Anmeldung erwähnt
- GHANASEV I ET AL: "SURFACE WAVE EIGENMODES IN A FINITE-AREA PLANE MICROWAVE PLASMA" JAPANESE JOURNAL OF APPLIED PHYSICS,JP,PUBLICATION OFFICE JAPANESE JOURNAL OF APPLIED PHYSICS. TOKYO, Bd. 36, PART 1, Nr. 1A, 1997, Seiten 337-344, XP000736128 ISSN: 0021-4922
- PATENT ABSTRACTS OF JAPAN vol. 1999, no. 05, 31. Mai 1999 (1999-05-31) & JP 11 045876 A (HITACHI LTD), 16. Februar 1999 (1999-02-16)
- Kummer: "Grundlagen der Mikrowellentechnik" 1986, VEB Verlag Technik , Berlin , pages 54,84-88
- MANFRED KUMMER: "Grundlagen der Mikrowellentechnik" 1986, VEB VERLAG TECHNIK BERLIN , BERLIN * Seite 54 * * Seite 84 - Seite 88 *

## Beschreibung

### Stand der Technik

Die Erfindung geht aus von einer Vorrichtung und einem damit durchgeführten Verfahren zur Erzeugung eines Plasmas, insbesondere zur Behandlung von Oberflächen, zur chemischen Umsetzung von Gasen oder zur Lichterzeugung, durch Mikrostrukturelektrodenentladungen nach der Gattung der unabhängigen Ansprüche.

Für die Behandlung von Oberflächen mit einem Plasmaverfahren ist es vorteilhaft, das Plasma so nah wie möglich an der zu behandelnden Oberfläche oder Substrat zu erzeugen, oder eine Plasmaquelle mit einem scharf begrenzten oder lokalen Plasmavolumen nahe an das zu behandelnde Substrat heranzuführen. Dies wird im Stand der Technik über sogenannte Mikrostrukturelektrodenentladungen realisiert, wobei dielektrische Platten mit Elektroden versehen werden, die sich in einem typischen Abstand von ca. 100 µm oder weniger befinden. Diese Art von Entladungen arbeiten bekanntermaßen in einem sehr weiten Druckbereich und weisen relativ scharfe Plasmagrenzflächen auf, d.h. es entstehen großflächige, aber lokal eng begrenzte, kleinvolumige Plasmen.

### Im Stand der Technik werden

Mikrostrukturelektrodenentladungen bisher ausschließlich mit Gleichspannung gezündet und betrieben. Dazu sei beispielsweise auf M. Roth et al., "Micro-Structure-Electrodes as Electronic Interface Between Solid and Gas Phase: Electrically Steerable Catalysts for Chemical Reaction in the Gas Phase", 1997, 1. Int. Conf. on Microreaction Technology, Frankfurt/Main und J.W. Frame, "Microdischarge Devices Fabricated in Silicon", 1997, Appl. Phys. Lett., 71, 9, 1165, verwiesen. Hochfrequenz- oder Mikrowellenanregungen wurden bisher nicht realisiert.

Aus Kummer, "Grundlagen der Mikrowellentechnik", VEB Verlag Technik, Berlin, 1986, ist weiter bereits bekannt, Mikrowellen über Hohlleiter oder Streifenleiter ("Microstrip-Technologie") zu führen. Im Fall der Streifenleiter ("Micro-Strips") wird dabei üblicherweise auf einem dielektrischen Substrat mit einer vielfach geerdeten metallischen Grundplatte eine metallische Leiterbahn aufgebracht, in die Mikrowellen eingekoppelt werden. Falls mehr als eine Leiterbahn auf der Grundplatte verläuft, kann auf die metallische Grundplatte auch verzichtet werden.

### Vorteile der Erfindung

Die erfindungsgemäße Vorrichtung und das damit durchgeführte erfindungsgemäße Verfahren haben gegenüber dem Stand der Technik den Vorteil, daß ein direkter Kontakt des erzeugten Plasmas mit der das Plasma erzeugenden Einrichtung, und insbesondere den als Elektroden dienenden Teilen dieser Einrichtung nicht erforderlich ist. Somit wird die Lebensdauer der gesamten erfindungsgemäßen Vorrichtung und insbesondere der als Mikrostrukturelektroden dienenden Führungsstruktur erheblich verlängert. Überdies ist die erfindungsgemäße Vorrichtung somit deutlich wartungsfreundlicher.

Weiterhin kann aufgrund der geringen Eindringtiefe von Strömen bei hohen Frequenzen das Elektrodenmaterial bzw. die Führungsstruktur (metallischer Hohlleiter oder Streifenleiter) zur Führung der eingekoppelten Mikrowellen in der das Plasma erzeugenden Einrichtung sehr dünn gehalten werden, wodurch sich die Fertigung erheblich vereinfacht. So beträgt die erforderliche Dicke bei einer Frequenz von 2,45 GHz materialabhängig lediglich einige µm. Dies gilt überdies auch für die Strukturen oder Bauteile zur Einkoppelung der Mikrowellen in die Führungsstruktur. Insbesondere kann die Führungsstruktur somit vorteilhaft auch aufgedampft werden.

Die Erzeugung eines lokalen oder räumlich eng begrenzten Plasmas durch Mikrowellen in einem oder vorzugsweise einer Vielzahl von voneinander isolierten Plasmabereichen erfolgt dann über ein zugeführtes Gas, das an der Führungsstruktur vorbei- oder durch diese hindurchgeführt wird, oder mit dem die Führungsstruktur beaufschlagt wird. Damit wird an der Oberfläche der Führungsstruktur zumindest bereichsweise in den Plasmabereichen und einem durch diesen definierten Plasmavolumen ein Gasplasma erzeugt.

Weitere Vorteile und vorteilhafte Weiterbildungen der Erfindung ergeben sich aus den in den Unteransprüchen aufgeführten Maßnahmen.

So ist es sehr vorteilhaft für die Lebensdauer der Einrichtung bzw. der Führungsstruktur als Mikrostrukturelektroden, wenn diese in der Umgebung der Plasmabereiche mit einer dielektrischen Schutzschicht überzogen wird. Dazu eignen sich vor allem keramische Schutzschichten. Durch diese Schutzschicht, die bei Gleichspannungsbetrieb nicht eingesetzt werden kann, wird die Lebensdauer der Mikrostrukturelektroden deutlich erhöht.

Daneben kann bei der Herstellung der Einrichtung zur Plasmaerzeugung und insbesondere zur Führung und Entladung der eingekoppelten Mikrowellen in der Führungstruktur auf bestehende Technologien zurückgegriffen werden. So erfolgt die Führung der Mikrowellen sehr vorteilhaft über eine bekannte Hohlleiteranordnung oder eine bekannte Micro-Strip-Anordnung, die über ebenfalls an sich bekannte Mikrostrukturierungsverfahren erzeugt und strukturiert werden.

Das Einkoppeln der von einem Mikrowellengenerator erzeugten Mikrowellen in die Führungsstruktur erfolgt über mindestens eine Einkoppelstruktur, die mit der Führungstruktur elektrisch leitend in Verbindung steht. Die Frequenz der zugeführten Mikrowellen beträgt vorteilhaft 300 MHz bis 300 GHz.

Die Führungsstruktur für die eingekoppelten Mikrowellen als Teil der Einrichtung zur Erzeugung der Gasentladung bzw. des Plasmas ist sehr vorteilhaft ein metallischer Hohlleiter, der mit einem vorzugsweise durchschlagfesten und verlustarmen Dielektrikum wie Siliziumdioxid gefüllt ist. Sie kann jedoch auch aus einer Anordnung von mindestens zwei, bevorzugt parallelen beabstandeten Metallplatten aufgebaut sein, deren Zwischenraum mit einem Dielektrikum ausgefüllt ist. Diese Anordnung hat aufgrund ihres einfacheren Aufbaus gegenüber dem geschlossenen Hohlleiter fertigungstechnische Vorteile.

Der Hohlleiter bzw. die Metallschichten des Hohlleiters oder die Metallplatten haben vorteilhaft eine Dicke bzw. einen Abstand, die oder der der Eindringtiefe der eingekoppelten Mikrowellen entspricht. Typische Werte, die beispielsweise aus Kummer, "Grundlagen der Mikrowellentechnik", VEB Verlag Technik, Berlin, 1986, bekannt sind, liegen im µm-Bereich bei einer typischen Ausdehnung des Hohlleiters bzw. der Metallplatten in Länge und/oder Breite im cm-Bereich.

Besonders vorteilhaft ist es, wenn in dem Hohlleiter als Führungsstruktur die H₁₀-Mode der eingekoppelten Mikrowellen angeregt und geführt wird, da in diesem Fall lediglich die Breite des Hohlleiters für die Ausbreitung der Mikrowellen kritisch ist und beispielsweise seine Länge, abgesehen von unvermeidbarer Dämpfung, weitgehend frei variiert werden kann.

Alternativ kann die Führungsstruktur vorteilhaft auch eine Anordnung von mindestens zwei metallischen, insbesondere parallelen Streifenleitern sein, die auf einer dielektrischen Platte verlaufen. Auch hier eignet sich beispielsweise Siliziumdioxid als Material für die Platte. Die Herstellung dieser Streifenleiter mit einer Dicke von einigen Eindringtiefen erfolgt bevorzugt über bekannte Mikrostrukturierungsverfahren oder Mikrostripstrukturierungstechniken.

Im Bereich der Führungsstruktur ist weiterhin mindestens ein, vorzugsweise jedoch eine Vielzahl von Plasmabereichen vorgesehen, die über eine Mikrostrukturierung der Führungstruktur erzeugt werden.

Diese Plasmabereiche sind in der Führungsstruktur vorgesehene Bohrungen. Typische Durchmesser dieser Bohrungen liegen vorteilhaft bei ca. 50 µm bis 1000 µm. Sie werden zweckmäßig in regelmäßiger Anordnung im Bereich der Führungsstruktur verteilt. Im Fall eines Hohlleiters als Führungsstruktur haben diese Bohrungen in Kombination mit der angeregten H₁₀-Mode überdies den großen Vorteil, daß das erzeugte elektrische Feld innerhalb des Hohleiters parallel zu den Bohrungen ausgerichtet und weitgehend homogen ist. Auch sind damit Feldstärkevariationen in Richtung der Breite des Hohlleiters im Vergleich zu höheren anregbaren Moden minimal.

Die Innenwand der Bohrungen und optional auch die gesamten Elektrodenflächen werden zur Vermeidung oder Minimierung einer Oberflächenbelastung oder eines Materialabtrages und einer damit einhergehenden allmählichen Zerstörung der Plasmabereiche bzw. der Führungsstruktur durch das erzeugte Plasma vorteilhaft mit einer dielektrischen, insbesondere keramischen Schutzschicht versehen. Diese dielektrische Schutzschicht beeinträchtigt die Propagation der Mikrowellen in der Führungsstruktur nur unwesentlich.

Die Erzeugung des Plasmas in den Plasmaerzeugungsbereichen erfolgt vorteilhaft bei einem Druck von 0,01 mbar bis 1 bar, wobei den Plasmabereichen über den Mikrowellengenerator und die Einkoppelstruktur vorteilhaft eine Mikrowellenleistung von jeweils ca. 1 mW bis 1 Watt zugeführt wird.

Das zugeführte Gas ist bevorzugt ein Edelgas, insbesondere Argon, He oder Xe, sowie Luft, Stickstoff, Wasserstoff, Acetylen oder Methan, das bevorzugt mit einem Gasfluß von ca. 10 sccm bis ca. 1000 sccm zugeführt wird. Diese Parameter skalieren jedoch im Einzelfall mit der gewählten Dimensionierung der Einrichtung zur Plasmaerzeugung und sind lediglich als typische Werte anzusehen. Sehr vorteilhaft ist weiter, daß die erfindungsgemäße Vorrichtung auch an Luft betrieben werden kann und damit eine oxidische Anregung von Oberflächen erzielt wird. Durch den weiten Druckbereich von Atmosphärendruck bis zum Feinvakuum in dem gearbeitet werden kann, werden überdies vielfältige Anwendungsmöglichkeiten erschlossen.

Die erfindungsgemäße Vorrichtung und das damit durchgeführten Verfahren eignen sich besonders zur Bearbeitung oder Aktivierung von Oberflächen eines Substrates oder zur Abscheidung von Schichten. Ihr besonderer Vorteil liegt dabei in der räumlich eng begrenzten Ausdehnung der Plasmabereiche und deren unmittelbarer Nähe zur Oberfläche des zu behandelnden Substrates.

### Zeichnung

Ausführungsbeispiele der Erfindung werden anhand der Zeichnungen und in der nachfolgenden Beschreibung näher erläutert. Es zeigt Figur 1 eine Einrichtung mit einer Führungstruktur mit Bohrungen, Figur 2 eine alternative Ausführungsform der Führungsstruktur, Figur 3 eine erste Gasführung bei einer Plasmabearbeitung eines Substrates mit einer Führungsstruktur und Figur 4 eine alternative Ausführungsform mit anderer Gasführung.

### Ausführungsbeispiele

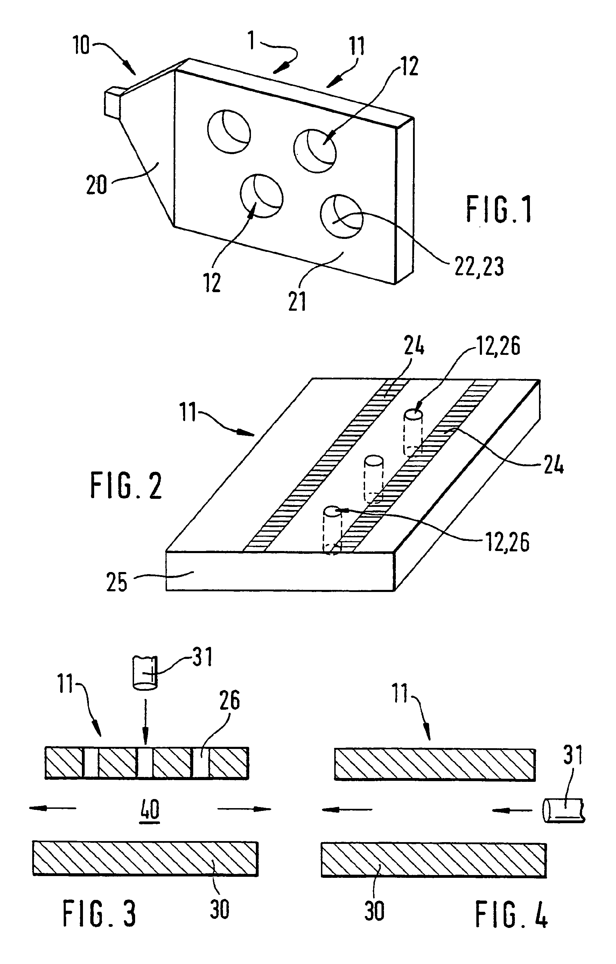

Die Figur 1 zeigt eine Einrichtung 1 mit einer Einkoppelstruktur 10, einer Führungsstruktur 11 und Plasmabereichen 12. Die Einkoppelstruktur 10 hat in diesem Fall die Form eines an sich aus der Mikrowellentechnik bekannten Hornes 20 und dient der Einkoppelung von Mikrowellen in die Führungsstruktur 11. Die Mikrowellen werden über einen nicht dargestellten, an sich bekannten Mikrowellengenerator erzeugt, der mit der Einkoppelstruktur 10 in Verbindung steht. Das Horn 20 geht elektrisch leitend in die Führungsstruktur 11 über, so daß mit dem Mikrowellengenerator über die Einkoppelstruktur 10 in die Führungsstruktur 11 Mikrowellen eingekoppelt werden.

Die Führungsstruktur 11 ist in diesem Beispiel als Hohlleiter 21 aus einem Metall wie Kupfer, Edelstahl, Gold oder Silber ausgebildet, der im Inneren beispielsweise mit Siliziumdioxid als durchschlagfestes, verlustarmes Dielektrikum 22 gefüllt ist. Der Hohlleiter 21 hat eine Dicke von bis zu einem mm. Seine Länge ist variabel, sollte aber ein Viertel der Wellenlänge der eingekoppelten Mikrowellen betragen. Seine Breite wird entsprechend der gewählten Hohlleitermode bestimmt.

Der Hohlleiter 21 ist weiter mit einer Vielzahl von Bohrungen 26 versehen, die regelmäßig angeordnet sind, und die die eng begrenzten, in der Umgebung der Bohrung 26 befindlichen Plasmabereiche 12 definieren. Der Durchmesser der einzelnen Bohrung 26 beträgt ca. 50 µm bis 1 mm. Die Einrichtung 1 ist somit eine Mikrostruktur, wobei innerhalb jedes Plasmabereiches 12 der Führungsstruktur 11 nach dem Zuleiten eines Gases ein Plasma gezündet wird. Die Innenwand 23 der Bohrungen 26 und optional die gesamten Elektrodenflächen der Führungsstruktur 11 sind weiter mit einer dielektrischen, insbesondere keramischen Beschichtung als Schutzschicht versehen, die beispielsweise aus Aluminiumoxid oder Siliziumdioxid besteht.

Die Frequenz der in die Führungsstruktur 11 eingekoppelten Mikrowellen liegt zweckmäßig zwischen 300 MHz bis 30 GHz, bevorzugt werden 900 MHz und 2,45 GHz verwendet. Der Hohlleiter 21 wird dabei bevorzugt so dimensioniert und die Frequenz der Mikrowellen bevorzugt derart gewählt, daß die H₁₀-Mode der eingekoppelten Mikrowellen in dem Hohlleiter 21 angeregt wird und sich ausbreitet.

Dazu muß der Fachmann im Einzelfall jeweils die Breite des Hohlleiters 21 und die Frequenz der Mikrowellen aufeinander abstimmen. Für die Anregung der H₁₀-Mode ist lediglich die Breite des Hohlleiters 21 eine kritische Größe, während beispielsweise dessen Länge lediglich hinsichtlich der Dämpfung der sich ausbreitenden Mikrowelle relevant ist. Die Leistung der eingekoppelten Mikrowellen wird weiter derart gewählt, daß sich für jeden Plasmaentladungsbereich 12 eine Leistung von ca. 1 mW bis zu ca. 1 Watt ergibt.

Die Figuren 3 und 4 erläutern den Betrieb der Einrichtung 1 zur Behandlung der Oberfläche eines Substrates 30 mit einem Plasma durch die mit der Einrichtung 1 in den Plasmabereichen 12 der Führungsstruktur 11 erzeugten Mikrostrukturelektrodenentladungen. Dazu wird gemäß Figur 3 ein Gas über eine Gaszuführung 31 von der dem Substrat 30 abgewandten Seite durch die Bohrungen 26 der Führungsstruktur 11 geführt. Dieses Gas strömt somit an der Oberfläche des Substrates 30 vorbei und dann seitlich ab. Ab einer minimalen eingekoppelten Mikrowellenleistung, die im wesentlichen von der Art des zugeführten Gases, des Gasflusses, des Druckes und der Dicke des Hohlleiters 21 abhängt, kommt es dann zu einer Plasmaerzeugung in den im wesentlichen über die Ausdehnung der Bohrung 26 definierten Plasmabereichen 12. Somit befindet sich zwischen der Führungsstruktur 11 und dem Substrat 30 zumindest bereichsweise ein Plasmavolumen 40, das von verschiedenen, je nach Abstand der Bohrungen 26 voneinander isolierten oder zusammengewachsenen Plasmabereichen 12 gebildet wird.

Das zugeführte Gas ist beispielsweise ein Inertgas bzw. Edelgas wie Stickstoff oder Argon zur Reinigung oder Aktivierung der Oberflächen des Substrates 30, es kann jedoch ebenso auch ein an sich bekanntes Reaktivgas wie Sauerstoff, Luft, Acetylen, Wasserstoff oder ein gas- oder dampfförmiges Precursor-Material wie eine siliziumorganische oder titanorganische Verbindung sein. Mit der Einrichtung 1 können somit je nach Wahl des zugeführten Gases auch chemische Reaktionen an der Oberfläche des Substrates induziert werden oder eine Oberflächenbeschichtung, beispielsweise in Form einer Hartstoffbeschichtung oder Verschleißschutzschicht, vorgenommen werden.

Die Erzeugung des Plasmas in dem Plasmabereich 12 mit Hilfe der in die Führungsstruktur 11 eingekoppelten Mikrowellen und unter Zuführung eines Gases erfolgt, je nach Dimensionierung der Führungsstruktur 11, der Art des zugeführten Gases, des Durchmessers der Bohrungen 26, der Breite des Hohlleiters 21 und der gewünschten Behandlung der Oberfläche bei einem Druck von ca. 0,01 mbar bis zu ca. 1 bar, der jeweils im Einzelfall vom Fachmann anhand einfacher Vorversuche zu ermitteln ist. Bevorzugt ist ein Druck von 10 mbar bis 200 mbar, wobei die Zufuhr des Plasmagases mit einem typischen Gasfluß von einigen sccm bis ca. 1000 sccm erfolgt. Dieser Wert ist jedoch im Einzelfall ebenfalls durch den Fachmann an die jeweiligen Prozeßparameter über Vorversuche anzupassen.

Die Figur 4 zeigt eine alternative Führung des zugeführten Gases über die Gaszuführung 31 als zweites Ausführungsbeispiel. Dabei strömt das Gas zwischen der Oberfläche des Substrates 30 und der Führungsstruktur 11 vorbei und wird nicht durch die Bohrungen 26 zugeführt. Ansonsten sind die Parameter zur Erzeugung des Plasmas in den Plasmabereichen 12 jedoch völlig analog dem mit Hilfe der Figuren 1 und 3 erläuterten Ausführungsbeispiel.

In einem dritten Ausführungsbeispiel besteht die Führungsstruktur 11, in leichter Abwandlung des Hohlleiters 21, aus zwei parallelen beabstandeten Metallplatten, deren Zwischenraum mit Siliziumdioxid gefüllt ist. Ansonsten ist die Leitstruktur 21 insbesondere hinsichtlich Dimensionierung, Bohrungen und Material jedoch völlig zu dem ersten Ausführungsbeispiel und der Figur 1 aufgebaut. Die Verwendung von zwei parallelen Metallplatten anstelle des Hohlleiters 21 hat den Vorteil, daß deren Herstellung gegenüber einem geschlossenen Hohlleiter 21 fertigungstechnisch einfacher und billiger zu realisieren ist. Die Führung und Ausbreitung der eingekoppelten Mikrowellen erfolgt in diesem Fall über eine kapazitive Kopplung der beiden Platten. Die Zufuhr des Gases erfolgt in diesem Ausführungsbeispiel ebenfalls analog den vorangehenden Ausführungsbeispielen, wie sie mit Hilfe der Figuren 3 oder 4 erläutert wurden.

Die Figur 2 erläutert als weiteres Ausführungsbeispiel eine alternative Ausführungsform der Führungsstruktur 11, wobei die Führung der eingekoppelten Mikrowellen in Micro-Strip-Technologie über Streifenleiter 24 erfolgt. In diesem Fall ist weiterhin das Horn 20 nicht erforderlich, da die Einkoppelung der von dem Mikrowellengenerator erzeugten Mikrowellen hier über koaxiale Stecker erfolgt.

Im einzelnen werden in diesem Beispiel auf einer dielektrischen Platte 25, die aus einem durchschlagfesten Material wie Siliziumdioxid besteht, mindestens zwei, vorzugsweise jedoch eine Vielzahl von metallischen Streifenleitern 24 aufgebracht. Diese Streifenleiter 24 verlaufen zweckmäßig parallel zu einander mit einem Abstand, der von der Frequenz und dem eingesetzten Dielektrikum abhängt, und bestehen bevorzugt aus Kupfer oder Gold, das optional auf einer galvanischen Verstärkung wie beispielsweise Nickel aufgebracht ist. Der optimale Abstand der Streifenleiter 24 zur Zündung und Aufrechterhaltung eines Plasmas in den Plasmabereichen 12 ist weiter abhängig von der Art des zugeführten Gases und des herrschenden Druckes und muß daher über einfache Vorversuche ermittelt werden.

Zwischen den Streifenleitern 24 sind weiterhin, analog zu Figur 1, Bohrungen 26 in der dielektrischen Platte 25 vorgesehen. Hinsichtlich der Dimensionierung der Führungsstruktur 11, der Bohrungen 26 sei auf die vorausgehenden Ausführungen im ersten Ausführungsbeispiel verwiesen. Insbesondere können die Bohrungen 26 auch in diesem Fall mit einer dielektrischen Beschichtung 27, beispielsweise in Form einer keramischen Schutzschicht, auf der Innenwand 23 versehen sein. Die Bohrungen 26 definieren somit wiederum lokal begrenzte Plasmabereiche 12, in denen über die eingekoppelten und über die Streifenleiter 24 geführten Mikrowellen bei Zufuhr eines Gases oder an Luft Mikrostrukturelektrodenentladungen zünden. Wenn die Bohrungen 26 dicht genug angeordnet sind, werden die in den Plasmabereichen 12 erzeugten Plasmen überkoppeln und es entwickelt sich ein lateral homogenes Plasma.

Die Gasführung im Fall einer Führungsstruktur 11 gemäß Figur 2 ist vollkommen analog den bereits erläuterten Ausführungsbeispielen und kann auf eine der mit Hilfe von Figur 3 oder 4 erläuterten Weise erfolgen, indem das Gas durch die Bohrungen 26 geleitet oder zwischen Substrat 30 und Führungsstruktur 11 vorbeigeführt wird.

### Bezugszeichenliste

- 1: Einrichtung

- 10: Einkoppelstruktur
- 11: Führungsstruktur
- 12: Plasmabereich

- 20: Horn
- 21: Hohlleiter
- 22: Dielektrikum
- 23: Innenwand
- 24: Streifenleiter
- 25: dielektrische Platte
- 26: Bohrung

- 30: Substrat
- 31: Gaszuführung

- 40: Plasmavolumen

## Patentansprüche

1. Vorrichtung zur Erzeugung eines Plasmas, insbesondere zur Behandlung von Oberflächen, zur chemischen Umsetzung von Gasen oder zur Lichterzeugung, mit einem Mikrowellengenerator zur Bildung von elektromagnetischen Mikrowellen und einer Einrichtung (1) zur Plasmaerzeugung,
wobei die Einrichtung (1) Mikrostrukturelektroden als eine Führungsstruktur (11) zur Mikrowellenleitung und eine Einkoppelstruktur (10) aufweist,
wobei der Mikrowellengenerator über die Einkoppelstruktur (10) mit der Führungstruktur (11) in Verbindung steht zur Einkopplung der vom Mikrowellengenerator gebildeten Mikrowellen in die Führungsstruktur (11) zur Plasmaerzeugung durch Entladungen mittels Mikrostrukturelektroden,
wobei die Führungsstruktur (11)
a) ein metallischer Hohlleiter (21) ist, der mit einem Dielektrikum (22), insbesondere Siliziumdioxid, Keramik oder Kapton, gefüllt ist, oder
b) eine Anordnung von mindestens zwei, insbesondere parallelen, beabstandeten Metallplatten ist, deren Zwischenraum mit einem Dielektrikum (22), insbesondere Siliziumdioxid, gefüllt ist, oder
c) eine Anordnung von mindestens zwei metallischen, insbesondere parallelen, Streifenleitern (24) ist, die auf einer dielektrischen Platte (25), insbesondere einem Substrat aus Siliziumdioxid, verlaufen, oder
d) eine zylindrische oder koaxiale Form mit einem zentralem Innenleiter
aufweist,
**dadurch gekennzeichnet, dass** die Führungsstruktur (11) mindestens eine Bohrung (26) mit einem Durchmesser von 10-1000 µm zur Ausbildung eines Plasmabereichs (12) aufweist.

2. Vorrichtung nach Anspruch 1, **dadurch gekennzeichnet, daß** zumindest die Innenwand (23) der Bohrung (26) mit einer dielektrischen Beschichtung, insbesondere einer keramischen Schutzschicht, versehen ist.

3. Vorrichtung nach Anspruch 1 oder 2, **dadurch gekennzeichnet, daß** eine insbesondere regelmäßige Anordnung einer Vielzahl von Bohrungen (26) vorgesehen ist.

4. Vorrichtung nach einem der Ansprüche 1 bis 3, **dadurch gekennzeichnet, daß** der Hohlleiter (21) eine Dicke bzw. die Metallplatten einen Abstand von 10 µm bis 1000 µm haben.

5. Verfahren zur Erzeugung eines insbesondere räumlich eng begrenzten Gasplasmas, mit einer Vorrichtung mit einem Mikrowellengenerator zur Bildung von elektromagnetischen Mikrowellen und einer Einrichtung (1) zur Plasmaerzeugung,
wobei die Einrichtung (1) Mikrostrukturelektroden als eine Führungsstruktur (11) zur Mikrowellenleitung und eine Einkoppelstruktur (10) aufweist,
wobei der Mikrowellengenerator über die Einkoppelstruktur (10) mit der Führungstruktur (11) in Verbindung steht zur Einkopplung der vom Mikrowellengenerator gebildeten Mikrowellen in die Führungsstruktur (11) zur Plasmaerzeugung durch Entladungen mittels Mikrostrukturetektroden,
wobei die Führungsstruktur (11)
a) ein metallischer Hohlleiter (21) ist, der mit einem Dielektrikum (22), insbesondere Siliziumdioxid, Keramik oder Kapton, gefüllt ist, oder
b) eine Anordnung von mindestens zwei, insbesondere parallelen, Metallplatten ist, deren Zwischenraum mit einem Dielektrikum (22), insbesondere Siliziumdioxid, gefüllt ist, oder
c) eine Anordnung von mindestens zwei metallischen, insbesondere parallelen, Streifenleitern (24) ist, die auf einer dielektrischen Platte (25), insbesondere einem Substrat aus Siliziumdioxid, verlaufen, oder
d) eine zylindrische oder koaxiale Form mit einem zentralem Innenleiter aufweist,
**dadurch gekennzeichnet dass** die Führungsstruktur (11) mindestens eine Bohrung (26) mit einem Durchmesser von 10-1000 µm zur Ausbildung eines Plasmabereichs (12) aufweist, wobei bei dem Verfahren Mikrowellen über die Einkoppelstruktur (10) in die Führungstruktur (11) eingekoppelt und dann über die Führungstruktur (11) geführt werden, und die geführten Mikrowellen in mindestens einem Plasmabereich (12) mit einem zugeführten Gas ein Plasma erzeugen.

6. Verfahren nach Anspruch 5, **dadurch gekennzeichnet, daß** das Gas durch in der Führungsstruktur (11) vorgesehene Bohrungen (26) geführt wird und das Plasma in der Bohrung (26) und/oder in einer Umgebung der Bohrung (26) erzeugt wird.

7. Verfahren nach Anspruch 5 oder 6, **dadurch gekennzeichnet, daß** das zugeführte Gas an der Führungsstruktur (11) vorbeigeführt oder diese mit dem zugeführten Gas beaufschlagt wird, so daß an der Oberfläche der Führungsstruktur (11) zumindest bereichsweise in einem Plasmavolumen (40) ein Plasma erzeugt wird.

8. Verfahren nach einem der Ansprüche 5 bis 7, **dadurch gekennzeichnet, daß** die Erzeugung des Gasplasmas bei einem Druck von 0,01 mbar bis 1 bar erfolgt.

9. Verfahren nach einem der Ansprüche 5 bis 8, **dadurch gekennzeichnet, daß** den Plasmaentladungsbereichen (12) eine Mikrowellenleistung von jeweils ca. 1 mW bis 1 Watt zugeführt wird.

10. Verfahren nach einem der Ansprüche 5 bis 9, **dadurch gekennzeichnet, daß** als Gas ein Edelgas, insbesondere Argon, Helium oder Xenon, Luft, Sauerstoff, Wasserstoff, Acetylen, Methan oder ein gas- oder dampfförmiges Precursor-Material zugeführt wird.

11. Verfahren nach Anspruch 5, **dadurch gekennzeichnet, daß** das Gas mit einem Gasfluß von bis zu 8.3 x 10⁻⁵ Standard-m³/s (5000 sccm) zugeführt wird.

12. Verfahren nach einem der Ansprüche 5 bis 11, **dadurch gekennzeichnet, daß** die Frequenz der zugeführten Mikrowellen 300 MHz bis 300 GHz beträgt.

13. Verfahren nach einem der Ansprüche 5 bis 12, **dadurch gekennzeichnet, dass** in der Führungsstruktur (11) die H₁₀-Mode der eingekoppelten Mikrowellen geführt wird.

14. Verwendung einer Vorrichtung zur Erzeugung eines Plasmas mit einem Mikrowellengenerator zur Bildung von elektromagnetischen Mikrowellen und einer Einrichtung (1) zur Plasmaerzeugung,
wobei die Einrichtung (1) Mikrostrukturelektroden als eine Führungsstruktur (11) zur Mikrowellenleitung und eine Einkoppelstruktur (10) aufweist,
wobei der Mikrowellengenerator über die Einkoppelstruktur (10) mit der Führungstruktur (11) in Verbindung steht zur Einkopplung der vom Mikrowellengenerator gebildeten Mikrowellen in die Führungsstruktur (11) zur Plasmaerzeugung durch Entladungen mittels Mikrostrukturelektroden wobei die Führungsstruktur (11)
a) ein metallischer Hohlleiter (21) ist, der mit einem Dielektrikum (22), insbesondere Siliziumdioxid, Keramik oder Kapton, gefüllt ist, oder
b) eine Anordnung von mindestens zwei, insbesondere parallelen, Metallplatten ist, deren Zwischenraum mit einem Dielektrikum (22), insbesondere Siliziumdioxid, gefüllt ist, oder
c) eine Anordnung von mindestens zwei metallischen, insbesondere parallelen, Streifenleitern (24) ist, die auf einer dielektrischen Platte (25), insbesondere einem Substrat aus Siliziumdioxid, verlaufen, oder
d) eine zylindrische oder koaxiale Form mit einem zentralem Innenleiter aufweist,
**dadurch gekennzeichnet dass** die Führungsstruktur (11) mindestens eine Bohrung (26) mit einem Durchmesser von 10-1000 µm zur Ausbildung eines Plasmabereichs (12) aufweist, zur Bearbeitung oder Aktivierung von Oberflächen eines Substrates (30), zur chemischen Stoffumsetzung, insbesondere in der Abgasreinigung, zur Lichterzeugung oder zur Abscheidung von Schichten auf dem Substrat (30) mit einem Plasma, insbesondere innerhalb eines räumlich eng begrenzten, in unmittelbarer Nähe zur Oberfläche des Substrates (30) befindlichen Plasmavolumens (40).

## Claims

1. Device for generating a plasma, especially for treating surfaces, for chemically converting gases or for producing light, comprising a microwave generator for forming electromagnetic microwaves and a unit (1) for generating plasma,
the unit (1) having microstructured electrodes as a guiding structure (11) for directing microwaves and a coupling-in structure (10),
the microwave generator being in connection with the guiding structure (11) by way of the coupling-in structure (10) for coupling the microwaves formed by the microwave generator into the guiding structure (11) to generate plasma by discharges by means of microstructured electrodes,
the guiding structure (11)
a) being a metal hollow conductor (21), which is filled with a dielectric (22), especially silicon dioxide, ceramic or Kapton, or
b) being an arrangement of at least two, especially parallel, spaced-apart metal plates, the space between which is filled with a dielectric (22), especially silicon dioxide, or
c) being an arrangement of at least two metal, especially parallel, strip conductors (24), which extend on a dielectric plate (25), especially a substrate of silicon dioxide, or
d) having a cylindrical or coaxial form with a central inner conductor,
**characterized in that** the guiding structure (11) has at least one bore (26) with a diameter of 10-1000 pm to form a plasma zone (12).

2. Device according to Claim 1, **characterized in that** at least the inner wall (23) of the bore (26) is provided with a dielectric coating, especially a ceramic protective layer.

3. Device according to Claim 1 or 2, **characterized in that** an arrangement, especially a regular arrangement, of a plurality of bores (26) is provided.

4. Device according to one of Claims 1 to 3, **characterized in that** the hollow conductor (21) has a thickness and the metal plates a spacing of 10 µm to 1000 µm.

5. Method for generating a gas plasma, especially a spatially closely confined gas plasma, by a device comprising a microwave generator for forming electromagnetic microwaves and a unit (1) for generating plasma,
the unit (1) having microstructured electrodes as a guiding structure (11) for directing microwaves and a coupling-in structure (10),
the microwave generator being in connection with the guiding structure (11) by way of the coupling-in structure (10) for coupling the microwaves formed by the microwave generator into the guiding structure (11) to generate plasma by discharges by means of microstructured electrodes,
the guiding structure (11)
a) being a metal hollow conductor (21), which is filled with a dielectric (22), especially silicon dioxide, ceramic or Kapton, or
b) being an arrangement of at least two, especially parallel, metal plates, the space between which is filled with a dielectric (22), especially silicon dioxide, or
c) being an arrangement of at least two metal, especially parallel, strip conductors (24), which extend on a dielectric plate (25), especially a substrate of silicon dioxide, or
d) having a cylindrical or coaxial form with a central inner conductor,
**characterized in that** the guiding structure (11) has at least one bore (26) with a diameter of 10-1000 µm to form a plasma zone (12), wherein, in the method, microwaves are coupled into the guiding structure (11) by way of the coupling-in structure and are then guided by way of the guiding structure (11), and the guided microwaves together with a supplied gas generate a plasma in at least one plasma zone (12).

6. Method according to Claim 5, **characterized in that** the gas is guided through bores (26) provided in the guiding structure (11) and the plasma is generated in the bore (26) and/or in a vicinity of the bore (26).

7. Method according to Claim 5 or 6, **characterized in that** the supplied gas is guided past the guiding structure (11) or the latter is impinged with the supplied gas, so that a plasma is generated on the surface of the guiding structure (11), at least in certain regions, in a plasma volume (40).

8. Method according to one of Claims 5 to 7, **characterized in that** the generation of the gas plasma takes place at a pressure of 0.01 mbar to 1 bar.

9. Method according to one of Claims 5 to 8, **characterized in that** a microwave power of in each case about 1 mW to 1 W is supplied to the plasma discharge zones (12).

10. Method according to one of Claims 5 to 9, **characterized in that** a noble gas, especially argon, helium or xenon, air, oxygen, hydrogen, acetylene, methane or a gaseous or vaporous precursor material is supplied as the gas.

11. Method according to Claim 5, **characterized in that** the gas is supplied with a gas flow of up to 8.3 × 10⁻⁵ standard m³/s (5000 sccm).

12. Method according to one of Claims 5 to 11, **characterized in that** the frequency of the supplied microwaves is 300 MHz to 300 GHz.

13. Method according to one of Claims 5 to 12, **characterized in that** the H₁₀ mode of the coupled-in microwaves is guided in the guiding structure (11).

14. Use of a device for generating a plasma comprising a microwave generator for forming electromagnetic microwaves and a unit (1) for generating plasma, the unit (1) having microstructured electrodes as a guiding structure (11) for directing microwaves and a coupling-in structure (10),
the microwave generator being in connection with the guiding structure (11) by way of the coupling-in structure (10) for coupling the microwaves formed by the microwave generator into the guiding structure (11) to generate plasma by discharges by means of microstructured electrodes,
the guiding structure (11)
a) being a metal hollow conductor (21), which is filled with a dielectric (22), especially silicon dioxide, ceramic or Kapton, or
b) being an arrangement of at least two, especially parallel, metal plates, the space between which is filled with a dielectric (22), especially silicon dioxide, or
c) being an arrangement of at least two metal, especially parallel, strip conductors (24), which extend on a dielectric plate (25), especially a substrate of silicon dioxide, or
d) having a cylindrical or coaxial form with a central inner conductor,
**characterized in that** the guiding structure (11) has at least one bore (26) with a diameter of 10-1000 µm to form a plasma zone (12), for working or activating surfaces of a substrate (30), for chemically converting substances, especially in exhaust emission control, for producing light or for depositing layers on the substrate (30) with a plasma, especially within a spatially closely confined plasma volume (40) located in the direct proximity of the surface of the substrate (30).

## Revendications

1. Dispositif pour produire un plasma, en particulier pour le traitement de surfaces, pour la conversion chimique de gaz ou pour la production de lumière au moyen d'un générateur de micro-ondes pour la formation de micro-ondes électromagnétiques et un dispositif (1) pour la production de plasma,
le dispositif (1) présentant des électrodes à microstructure en tant que structure de guidage (11) pour la conduction des micro-ondes et une structure d'injection (10),
le générateur de micro-ondes étant en liaison par le biais de la structure d'injection (10) avec la structure de guidage (11) pour l'injection des micro-ondes formées par le générateur de micro-ondes dans la structure de guidage (11) pour la production de plasma par décharges au moyen d'électrodes à microstructure,
la structure de guidage (11)
a) étant un conducteur métallique creux (21), qui est rempli d'un diélectrique (22), notamment du dioxyde de silicium, de la céramique ou du kapton, ou
b) étant un agencement d'au moins deux plaques métalliques, notamment parallèles et espacées, dont l'espace intermédiaire est rempli d'un diélectrique (22), notamment de dioxyde de silicium, ou
c) étant un agencement d'au moins deux rubans conducteurs (24) métalliques, notamment parallèles, qui s'étendent sur une plaque diélectrique (25), notamment un substrat en dioxyde de silicium, ou
d) présentant une forme cylindrique ou coaxiale
avec un conducteur interne central,
**caractérisé en ce que** la structure de guidage (11) présente au moins un alésage (26) avec un diamètre de 10 à 1000 µm pour créer une zone plasmatique (12).

2. Dispositif selon la revendication 1, **caractérisé en ce qu'**au moins la paroi interne (23) de l'alésage (26) est pourvue d'un revêtement diélectrique, notamment d'une couche de protection céramique.

3. Dispositif selon la revendication 1 ou 2, **caractérisé en ce qu'**un agencement notamment régulier d'une pluralité d'alésages (26) est prévu.

4. Dispositif selon l'une quelconque des revendications 1 à 3, **caractérisé en ce que** le conducteur creux (21) présente une épaisseur, ou les plaques métalliques présentent un espacement de 10 µm à 1000 µm.

5. Procédé pour produire un plasma de gaz notamment étroitement limité spatialement, avec un dispositif comprenant un générateur de micro-ondes pour la formation de micro-ondes électromagnétiques et un dispositif (1) pour la production de plasma,
dans lequel le dispositif (1) présente des électrodes à microstructure en tant que structure de guidage (11) pour la conduction des micro-ondes et une structure d'injection (10),
le générateur de micro-ondes étant en liaison par le biais de la structure d'injection (10) avec la structure de guidage (11) pour l'injection des micro-ondes formées par le générateur de micro-ondes dans la structure de guidage (11) pour la production de plasma par décharges au moyen d'électrodes à microstructure,
la structure de guidage (11)
a) étant un conducteur métallique creux (21), qui est rempli d'un diélectrique (22), notamment du dioxyde de silicium, de la céramique ou du kapton, ou
b) étant un agencement d'au moins deux plaques métalliques, notamment parallèles, dont l'espace intermédiaire est rempli d'un diélectrique (22), notamment de dioxyde de silicium, ou
c) étant un agencement d'au moins deux rubans conducteurs (24) métalliques, notamment parallèles, qui s'étendent sur une plaque diélectrique (25), notamment un substrat en dioxyde de silicium, ou
d) présentant une forme cylindrique ou coaxiale avec un conducteur interne central,
**caractérisé en ce que** la structure de guidage (11) présente au moins un alésage (26) avec un diamètre de 10 à 1000 µm pour créer une zone plasmatique (12), des micro-ondes étant injectées par le biais de la structure d'injection (10) dans la structure de guidage (11) lors du procédé, puis étant guidées par le biais de la structure de guidage (11), et les micro-ondes guidées produisant un plasma dans au moins une région plasmatique (12) avec un gaz acheminé.

6. Procédé selon la revendication 5, **caractérisé en ce que** le gaz est guidé à travers des alésages (26) prévus dans la structure de guidage (11) et le plasma est produit dans l'alésage (26) et/ou dans un environnement de l'alésage (26).

7. Procédé selon la revendication 5 ou 6, **caractérisé en ce que** le gaz acheminé est guidé devant la structure de guidage (11) ou celle-ci est sollicitée avec le gaz acheminé, de sorte qu'au moins en partie un plasma soit produit dans un volume de plasma (40) sur la surface de la structure de guidage (11).

8. Procédé selon l'une quelconque des revendications 5 à 7, **caractérisé en ce que** la production du plasma de gaz a lieu à une pression de 0,01 mbar à 1 bar.

9. Procédé selon l'une quelconque des revendications 5 à 8, **caractérisé en ce que** l'on achemine aux régions de décharge plasmatique (12) une puissance de micro-ondes à chaque fois d'environ 1 mW à 1 watt.

10. Procédé selon l'une quelconque des revendications 5 à 9, **caractérisé en ce que** l'on achemine en tant que gaz un gaz noble, notamment de l'argon, de l'hélium ou du xénon, de l'air, de l'oxygène, de l'hydrogène, de l'acétylène, du méthane ou un matériau précurseur formant du gaz ou de la vapeur.

11. Procédé selon la revendication 5, **caractérisé en ce que** le gaz est acheminé avec un flux de gaz allant jusqu'à 8,3 x 10⁻⁵ m³ standard/s (5000sccm).

12. Procédé selon l'une quelconque des revendications 5 à 11, **caractérisé en ce que** la fréquence des micro-ondes acheminées est de 300 MHz à 300 GHz.

13. Procédé selon l'une quelconque des revendications 5 à 12, **caractérisé en ce que** le mode H₁₀ des micro-ondes injectées est guidé dans la structure de guidage (11).

14. Utilisation d'un dispositif pour produire un plasma avec un générateur de micro-ondes pour former des micro-ondes électromagnétiques et un dispositif (1) pour la production de plasma,
le dispositif (1) présentant des électrodes à microstructure en tant que structure de guidage (11) pour le guidage de micro-ondes et une structure d'injection (10),
le générateur de micro-ondes étant en liaison par le biais de la structure d'injection (10) avec la structure de guidage (11) pour l'injection des micro-ondes formées par le générateur de micro-ondes dans la structure de guidage (11) pour la génération de plasma par décharges au moyen d'électrodes à microstructure,
la structure de guidage (11)
a) étant un conducteur métallique creux (21), qui est rempli d'un diélectrique (22), notamment du dioxyde de silicium, de la céramique ou du kapton, ou
b) étant un agencement d'au moins deux plaques métalliques, notamment parallèles, dont l'espace intermédiaire est rempli d'un diélectrique (22), notamment de dioxyde de silicium, ou
c) étant un agencement d'au moins deux rubans conducteurs (24) métalliques, notamment parallèles, qui s'étendent sur une plaque diélectrique (25), notamment un substrat en dioxyde de silicium, ou
d) présentant une forme cylindrique ou coaxiale
avec un conducteur interne central, **caractérisée en ce que** la structure de guidage (11) présente au moins un alésage (26) avec un diamètre de 10 à 1000 µm pour créer une zone plasmatique (12), pour le traitement ou l'activation de surfaces d'un substrat (30), pour la conversion chimique de substances, notamment dans l'épuration des gaz d'échappement, pour la production de lumière ou pour la déposition de couches sur le substrat (30) avec un plasma, notamment à l'intérieur d'un volume de plasma (40) se trouvant à proximité immédiate de la surface du substrat (30), notamment étroitement limité spatialement.
